# EUROPEAN PATENT APPLICATION

(11) **EP 1 684 365 A2**
(43) Date of publication of application: **26.07.2006**
(21) Application number: 06000519.6
(22) Date of filing: 11.01.2006
(51) Int. Cl.: H01L 51/10, H01L 51/30

(54) **Transistor**

(30) Priority: 20.01.2005 JP 2005012458; 21.02.2005 JP 2005044010
(71) Applicant: FUJI ELECTRIC HOLDINGS CO., LTD., Kawasaki-shi, Kanagawa 210-0856 (JP)
(72) Inventor: Kawakami, Haruo, Yokosuka-shi Kanagawa 240-0194 (JP); Kato, Hisato, Yokosuka-shi Kanagawa 240-0194 (JP); Maeda, Takahiko, Yokosuka-shi Kanagawa 240-0194 (JP); Sekine, Nobuyuki, Yokosuka-shi Kanagawa 240-0194 (JP)
(74) Representative: Appelt, Christian W.

(57) **Abstract**

The thin film field effect transistor according to the invention includes a gate electrode (11); a gate insulator film (12) on gate electrode (11); a first organic electronic material film (13) containing a first organic electronic material on gate insulator film (12); a source electrode (15) and a drain electrode (14) spaced apart from each other on first organic electronic material film (13); first organic electronic material film (13) including a portion (16) between source electrode (15) and drain electrode (14), portion (16) being in contact with gate insulator film (12); portion (16) providing a current with a path, the current being controlled by the potential of gate electrode (11); a second organic electronic material film (30) in contact with the surface of first organic electronic material film (13) opposite to portion (16); and second organic electronic material film (30) containing a second organic electronic material and an electron acceptor or an electron donor. The thin film field effect transistor according to the invention facilitates accumulating electric charges in the channel on the gate insulator film and realizing a high response frequency.

## Description

### FIELD OF THE INVENTION

The present invention relates to thin film transistors which use organic electronic materials.

### BACKGROUND OF THE INVENTION

Recently, flat panel displays for information equipments are spreading remarkably. Among the flat panel displays, the liquid crystal display controls the ON and OFF of the back lights utilizing the optical shutter function of the liquid crystal and obtains colors using color filters. In contrast to this, every pixel in the organic EL display (or the organic LED display) emits light. Therefore, the view angle for the organic EL display is wide. Moreover, since the organic EL display does not need any back light, it is possible to make the organic EL display to be thin and it is also possible to form the organic EL display on a flexible substrate. In addition, the organic EL display exhibits many other merits. Due to the advantages described above, the organic EL display is expected to be a display of next generation.

The driving systems for driving the flat panel displays may be divided roughly into two types. A first driving systems is the so-called passive matrix type driving system (the duty driving system or the simple matrix driving system). The passive matrix type driving system combines electrode stripes in matrix such that pixels are formed at the cross points of electrode stripe lines and electrode stripe rows. The passive matrix type driving system makes the selected pixel at the cross point of the selected electrode stripe line and the selected electrode stripe row, selected by the drive signals applied thereto, emit light. The signals for light emission control are scanned usually line by line in time sequence and applied simultaneously to the rows on the same line. Each pixel is not provided usually with any active device. The pixels on each electrode stripe line are controlled to emit light only during the duty period thereof in the line scanning period.

A second driving system is the so-called active matrix type driving system that provides each pixel with a switching device such that the pixels on the same electrode stripe line are capable of emitting light over the line scanning period. Now, it is assumed that the entire panel plane having 100 pixel lines × 150 pixel rows is made to emit light at the display luminance of 100 Cd/m². Since each pixel is always emitting light basically in the active matrix type driving system, it will be enough to make each pixel emit light at the luminance of 100 Cd/m², if the area ratio of the pixels and various loses are not considered. In the passive matrix type driving system, the duty ratio for driving each pixel is 1/100 and each pixel emits light during the duty period (selected period). Therefore, for obtaining the same luminance in the passive matrix type driving system, it is necessary to make each pixel emit light in the light emitting period at the luminance of 10000 Cd/m², 100 times as high as the luminance of 100 Cd/m² for the pixel in the active matrix type driving system.

For increasing the light emitting luminance, it is effective to increase the current made to flow to the light emitting devices. However, it has been known that the light emission efficiency of the organic EL light emitting device, for example, is lowered as the current made to flow thereto is increased. Due to this light emission efficiency lowering, the electric power consumption in the passive matrix type driving system will be larger than the electric power consumption in the active matrix type driving system, if compared with each other at the same display luminance. If the current made to flow to the organic EL device is increased, the materials in the organic EL device will be deteriorated by heat generation and the life of the organic EL device will be shortened. For obtaining the same display luminance, it will be necessary to elongate the light emitting period, if the maximum current made to flow to the organic EL device is limited for obtaining a high light emission efficiency and a long device life. However, since the duty ratio that determines the light emitting period for the passive matrix type driving system is inversely proportional to the number of pixel lines on the panel, an elongated light emitting period limits the display capacity (the number of drivable lines). Due to these reasons, it has been necessary to employ the active matrix type driving system to realize a high definition display panel having a wide display area. A system, which employs a thin film transistor for the switching device in the usual active matrix driving, has been known.

For the active matrix type driving system suited for a high definition display panel having a wide display area, a thin film transistor (hereinafter referred to as a "TFT") that uses polysilicon is used most widely for the pixel switching devise. However, the process temperature for forming the TFT that uses polysilicon is 250 °C or higher, which makes it hard to use a flexible plastic substrate.

For obviating the problems which the conventional display panels pose, it has been proposed to employ an organic thin film transistor.

JP P 2001 - 250680 A Publication (Patent Document 1) discloses the series connection of an organic thin film rectifier and an organic thin film light emitting device. WO01/15233 Pamphlet (Patent Document 2) discloses the pixel drive control by an organic thin film transistor. As disclosed in the Patent Document 2, it is possible to employ a low-temperature manufacturing process, since the driving device is formed of organic materials. Therefore, it is possible to use a flexible plastic substrate. Since low-cost materials and a low-cost process may be selected, it is also possible to reduce the manufacturing costs.

[Patent Document 1] JP P 2001 - 250680 A Publication
[Patent Document 2] WO01/15233 Pamphlet
[Patent Document 3] JP P 2004 - 47977 A Publication
[Non-patent Document 1] H. Fuchigami, Applied Physics Letters, Vol. 63 (1993), p. 1372

However, the following problems are posed on the organic thin film transistor.

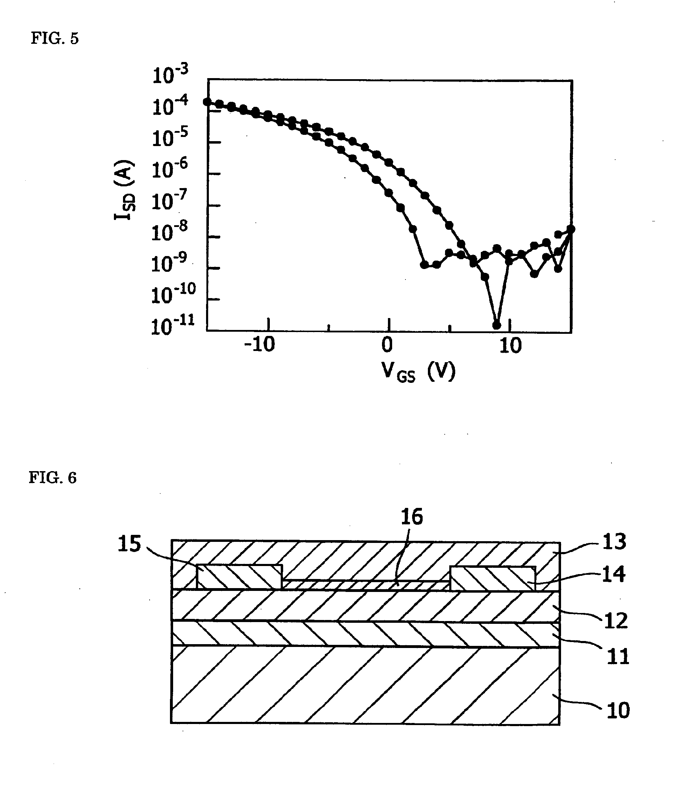

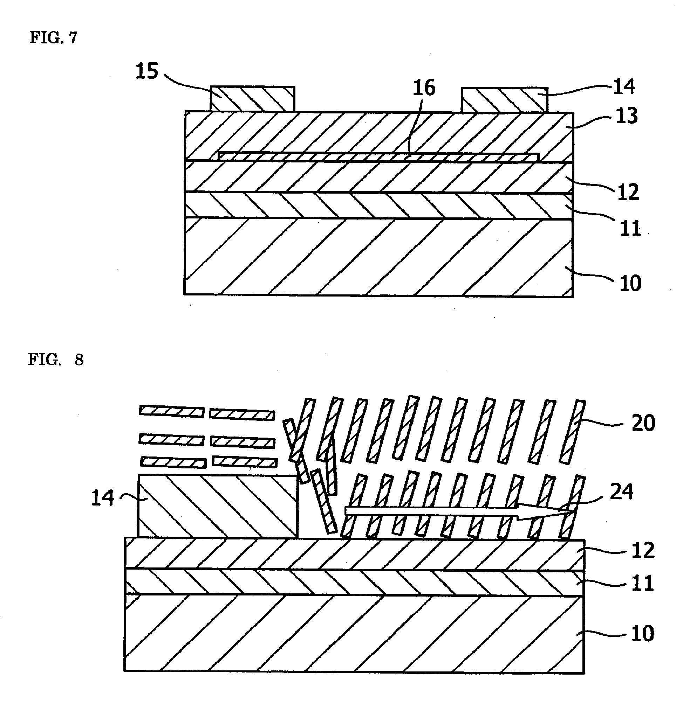

The modulation frequency, at which the current between the source and the drain is modulated with the gate voltage in the organic thin film transistor, is still low and the low modulation frequency is very hazardous for using the organic thin film transistor in practice. The typical structure for the organic thin film transistor may be classified into the so-called bottom contact structure shown in FIG. 6 and the so-called top contact structure shown in FIG. 7. In the bottom contact structure, a source electrode and a drain electrode are formed directly on a gate insulator film or above a gate insulator film with a bonding layer interposed between the source and drain electrodes and the gate insulator film. Then, an organic electronic material film is formed over the source and drain electrodes. In the top contact structure, an organic electronic material film is formed on a gate insulator film. Then, a source electrode and a drain electrode are formed on the organic electronic material film. In any of the structures, electric charges are induced in the portion of the organic electronic material film in contact with the gate insulator film. A current is made to flow due to the migration of the induced electric charges caused by the voltage applied between the source electrode and the drain electrode. The current path between the source electrode and the drain electrode is called the "channel". Usually, the channel is formed in the very thin portion of the organic electronic material film including several molecular layers.

The organic electronic materials used for the organic thin film transistor include pentacene, thiophene, a hexythiophene polymer, a fluorene thiophene polymer, copper phthalocyanine, and fullerene. When a low molecular material such as pentacene, thiophene, copper phthalocyanine, and fullerene is deposited by vacuum deposition, a polycrystalline thin film is obtained. The crystal orientation is different depending on the film deposition conditions and the kind of the substrate used. The crystal orientation greatly affects the transistor characteristics. In the case of pentacene used most widely, it is known that the pentacene molecule orients in such a manner that the longitudinal direction of the pentacene molecule is slant, on the metal oxide used for the gate insulator film, to the substrate. It is also known that the longitudinal direction of the pentacene molecule is parallel, on the metal film used for the source electrode and the drain electrode, to the substrate. The electrical resistance of pentacene in perpendicular to the longitudinal direction of the molecule thereof is lower than the electrical resistance of pentacene in parallel to the longitudinal direction of the molecule thereof. Therefore, the crystal orientation on the insulator film is preferable in the structures shown in FIGs. 6 and 7, in which the current flows in parallel to the gate insulator film. In the bottom contact structure, distortions are caused in the pentacene crystal in the boundary between the gate insulator film and the source electrode and in the boundary between the gate insulator film and the drain electrode. The crystal distortions caused increase the electrical resistance in the boundary between the gate insulator film and the source electrode and the electrical resistance in the boundary between the gate insulator film and the drain electrode (cf. FIG. 8).

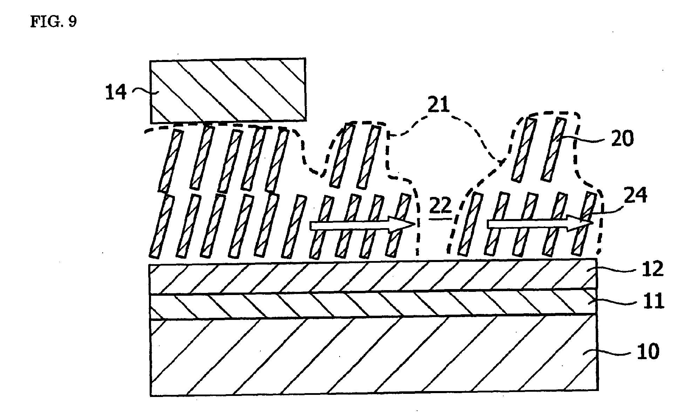

The top contact is the structure for avoiding the problems of the bottom contact structure as described above. Since the film of pentacene and such an organic electronic material is formed only on the gate insulator film in the top contact structure, any discontinuity is not caused in the crystal orientation. Due to this, the charge mobility in the top contact structure is usually higher than the charge mobility in the bottom contact structure. However, electrical resistance increase is caused in the top contact structure, since the organic electronic material film is between the current path (channel) on the gate insulator film and the source and drain electrodes. The electrical resistance increase is caused partly because the electrical resistance in the longitudinal direction of the molecule is higher than the electrical resistance perpendicular to the longitudinal direction of the molecule in the film of pentacene and such an organic electronic material. For obviating this problem, it is desirable to reduce the thickness of the organic electronic material film. However, the crystal of the organic electronic material usually grows like islands on the substrate as shown in FIG. 9. Therefore, when the film thickness is thin, it is impossible for the organic electronic material to cover the entire substrate surface, causing spatial defects 22. Since spatial defects 22 and such defects increase the electrical resistance against a current 24 in the channel, the resistance of the transistor increases. Therefore, it is necessary for the organic electronic material film to be thicker than a certain value. Therefore, the above described problem has not been solved yet.

Fuchigami (Non-patent Document 1) discloses an organic thin film transistor that employs poly(2, 5-thienylene vinylene), which is an electrically conductive polymer, for an active layer without depending on the charge injection form the outside. In the organic thin film transistor, the organic electronic material is slightly doped with oxygen that works as an electron acceptor, providing the organic electronic material with electrical conductivity. However, it is hard to control the concentration of the oxygen used for an electron acceptor. Moreover, since it is impossible to suppress the current in the OFF-state, the ON/OFF ratio is low.

JP P 2004 - 47977 A Publication (Patent Document 3) discloses a technique that buries a carrier generating layer containing a metallic material in an organic semiconductor layer and takes out positive and negative charges from the carrier generating layer to make a p-type channel and an n-type channel work simultaneously. However, when the metallic material for the carrier generating layer is deposited on the film of an organic material by the vacuum deposition method and such a deposition method, the organic material will be damaged by the heat caused by the vacuum deposition, deteriorating the organic electronic material and impairing the properties thereof. When the p-type and n-type channels are made to work simultaneously, the response frequency will be unstabilized due to the mobility difference between the positive and negative charges.

In any of the conventional structures described above, high electrical resistance exists between the source and drain electrodes and the channel. As described earlier, electric charges are induced in the portion of the organic electronic material film in contact with the gate insulator film by the gate voltage applied to the gate electrode in the field effect transistor and a current is made to flow based on the induced electric charges migrated by the voltage applied between the source electrode and the drain electrode. In other words, the time constant determined by the electrostatic capacitance of the gate insulator film and the electrical resistance of the path, through which electric charges are accumulated in the electrostatic capacitance, are the limiting factors limiting the frequency characteristics of the transistor, posing a serious problem.

In view of the foregoing, it would be desirable to provide an organic thin film transistor that facilitates accumulating electric charges on the gate insulator film thereof and realizing a high response frequency.

### SUMMARY OF THE INVENTION

According to a first aspect of the invention, there is provided a thin film field effect transistor including:
a gate electrode;
a gate insulator film on the gate electrode;
a first organic electronic material film on the gate insulator film, the first organic electronic material film containing a first organic electronic material;
a source electrode in contact with the first organic electronic material film;
a drain electrode in contact with the first organic electronic material film;
the source electrode and the drain electrode being spaced apart from each other;
the first organic electronic material film including a portion between the source electrode and the drain electrode, the portion of the first organic electronic material film being in contact with the gate insulator film, the portion of the first organic electronic material film providing a current with a path, the current being controlled by the potential of the gate electrode;
a second organic electronic material film on the surface of the first organic electronic material film between the source electrode and the drain electrode, the surface being on the side opposite to the portion of the first organic electronic material film in contact with the gate insulator film; and
the second organic electronic material film containing a second organic electronic material and an electron acceptor or an electron donor.
According to a second aspect of the invention, there is provides a thin film field effect transistor including:
a gate electrode;
a gate insulator film on the gate electrode;
a first organic electronic material film on the gate insulator film, the first organic electronic material film containing a first organic electronic material;
a source electrode above the first organic electronic material film;
a drain electrode above the first organic electronic material film;
the source electrode and the drain electrode being spaced apart from each other;
the first organic electronic material film including a portion in contact with the gate insulator film, the portion of the first organic electronic material film providing a current with a path, the current being controlled by the potential of the gate electrode;
a second organic electronic material film between the first organic electronic material film and the source electrode, the second organic electronic material film being between the first organic electronic material film and the drain electrode; and
the second organic electronic material film containing a second organic electronic material and an electron acceptor or an electron donor.

Advantageously, at least one of the first organic electronic material and the second organic electronic material is an acenic material described by the following structural formula (I), 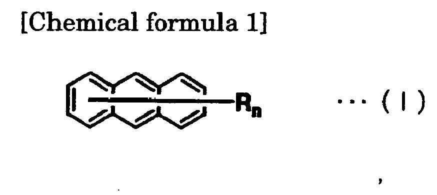 wherein R represents hydrogen, an alkyl group having from 1 to 6 carbons which may have one or more substituents, an aryl group which may have one or more substituents, an alkoxy group having from 1 to 6 carbons which may have one or more substituents, 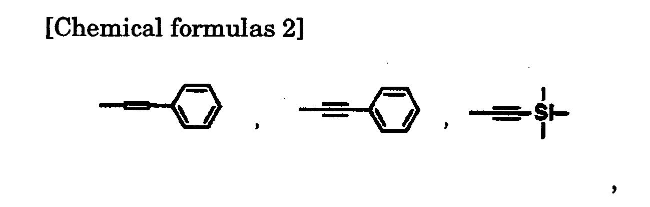 or a residue that forms with an anthracene skeleton an aromatic ring or a heterocycle and n represents any of the integers 1 through 10.

Advantageously, the electric charge that flows through the first organic electronic material is a hole and the electron acceptor is 2,3,5,6-tetrafluoro-7,7,8,8-tetracyanoquinodimethane (hereinafter referred to as "F₄TCNQ") described by the following structural formula (II). 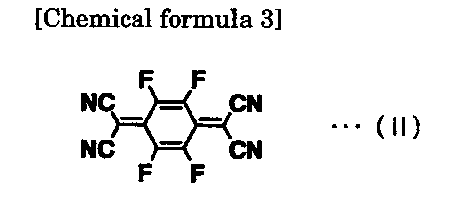 Advantageously, the doping amount of F₄TCNQ is 20 atomic % or less.

Advantageously, the electric charge that flows through the first organic electronic material is an electron and the electron donor is pyronine B described by the following structural formula (III). 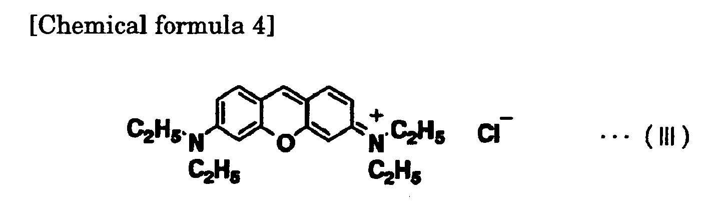 Advantageously, the doping amount of pyronine B is 20 atomic % or less.

Although pentacene, thiophene, a hexythiophene polymer, a fluorene thiophene polymer, copper phthalocyanine, and fullerene are preferable for the organic electronic material, many other organic electronic material may be employable.

Although various metallic materials and organic electrically conductive materials are employable for the gate electrode, the gate electrode material is selected considering the adhesiveness to the substrate and the easiness of forming the gate insulator film thereon. For example, tantalum is preferable for the gate electrode, since the anodic oxide film obtained by anodic oxidation of tantalum is employable for the gate insulator film.

Various metal oxides such as the oxides of silicon, aluminum, tantalum, titanium, strontium and barium, anodic oxide films of these metals, and mixed oxides of these metals are employable for the gate insulator film. Polymers such as polystyrene, poly(vinyl alcohol), poly(vinyl phenol) and an acrylic polymer may be used for the gate insulator film. Since the dielectric permeability of many metal oxides is higher than the dielectric permeability of the polymer materials, the metal oxide gate insulator film facilitates driving the transistor with a relatively low voltage. In contrast, since the dielectric permeability of the polymer material is relatively low, the polymer gate insulator film facilitates high-speed response.

Various metallic materials and organic electrically conductive materials are employable for the source electrode and the drain electrode. When the electric charges migrating through the organic electronic material are holes, gold exhibiting a high work function is used for the electrode material for enhancing hole injection at the source electrode and for suppressing electron injection at the drain electrode.

Various glass substrates and polymer films of polyimide, poly(ethyl-ether ketone) (PEEK) and poly(ethylene terephthalate) (PET) are used for the substrate, on which the constituent films and layers described above are formed.

Preferably, the doping amount of the electron acceptor or the electron donor to the second organic electronic material is 20 atomic % or less. If the doping amount exceeds 20 atomic % to the higher side, the electron states characteristic of the organic electronic material will be disturbed too much, impairing the characteristics of the organic electronic material. The additive percentage controllable by the presently available technique is 0.01 atomic %, which is the substantial lower limit.

Although R in the above described structural formula (I) of the organic electronic material is hydrogen, methyl, phenyl, p-methoxyphenyl, and methoxy, 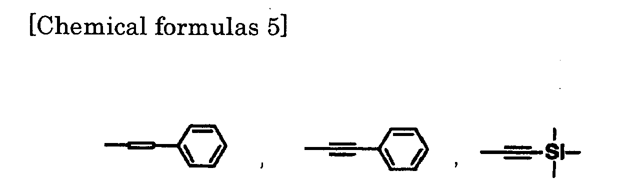 R is not always limited to those described above. Alternatively, R may be a residue that forms an aromatic ring or a heterocycle with an anthracene skeleton. For example, R may be a residue that forms an aromatic ring or a heterocycle through the condensation with an anthracene skeleton. For example, R may have any of the structures described by the following structural formulas I-13 through I-15 and I-18 through I-26.

In detail, the acenic materials described by the following structural formulas (I-1) through (I-26) may be used in the organic electronic material film.

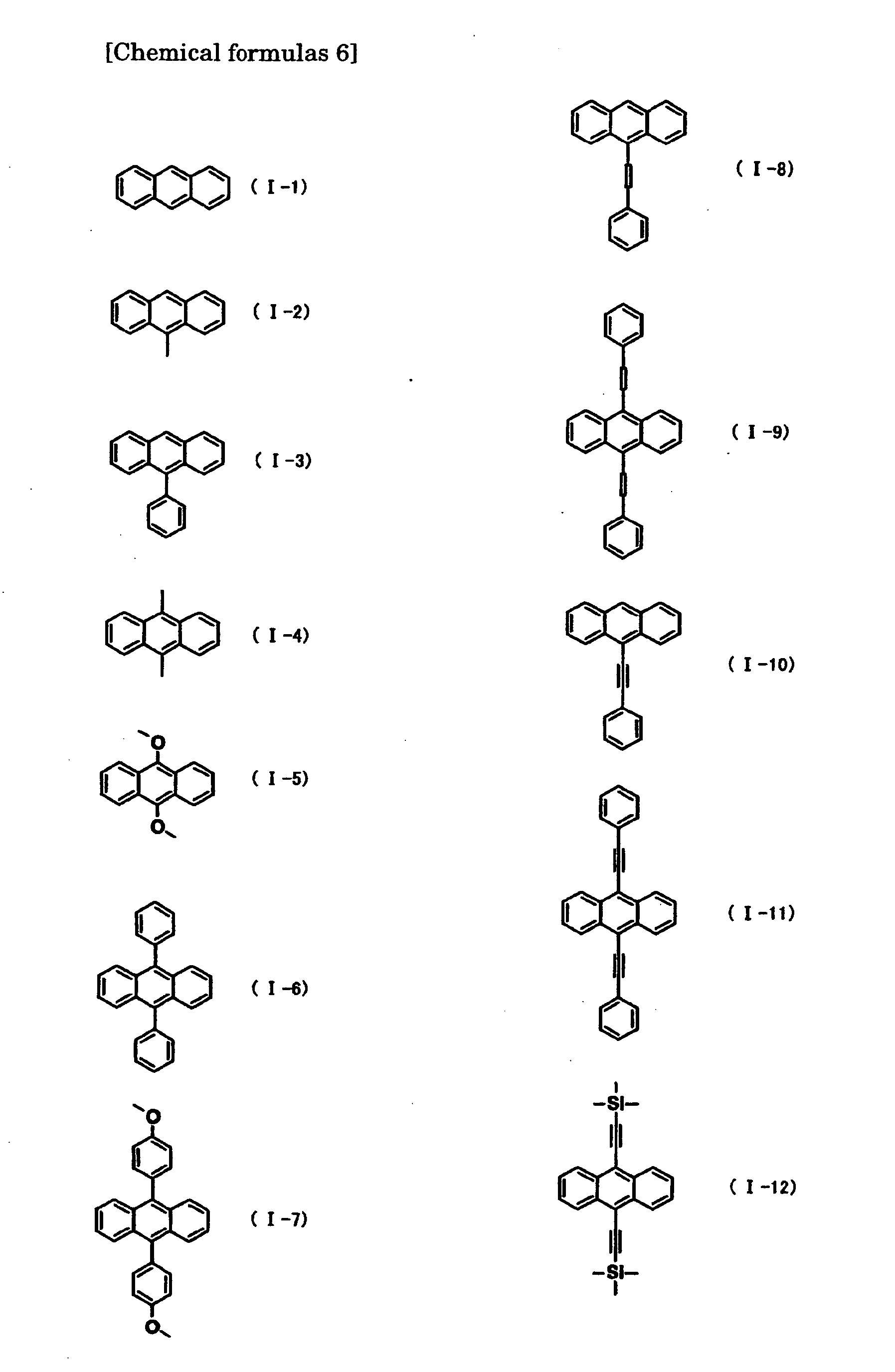

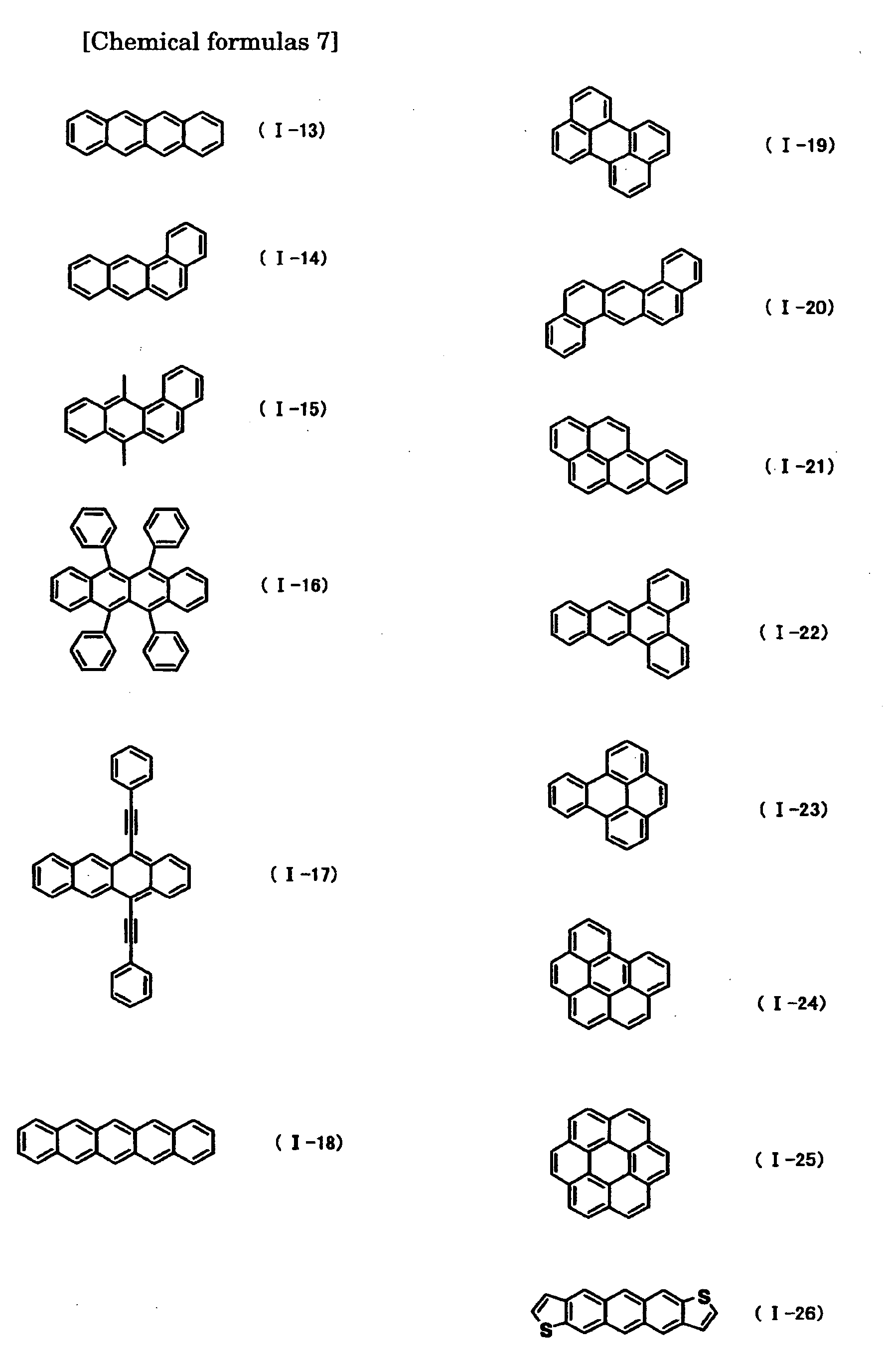

According to the invention, there is also provided a first method for manufacturing a thin film field effect transistor that controls, with the potential of a gate electrode, the current flowing through the portion of a first organic electronic material film in contact with a gate insulator film, the first method including the steps of:
preparing a substrate;
arranging the gate electrode on the substrate;
arranging the gate insulator film on the gate electrode;
arranging the first organic electronic material film on the gate insulator film, the first organic electronic material film containing a first organic electronic material;
arranging a source electrode and a drain electrode in advance or in subsequent to the step of arranging the first organic electronic material film such that the source electrode and the drain electrode are in contact with the first organic electronic material film and such that the source electrode and the drain electrode are spaced apart from each other; and
arranging a second organic electronic material film containing a second organic electronic material and an electron acceptor or an electron donor on the surface of the first organic electronic material film between the source electrode and the drain electrode, the surface being on the side opposite to the portion of the first organic electronic material film in contact with the gate insulator film.
Moreover, there is provided a second method for manufacturing a thin film field effect transistor that controls, with the potential of a gate electrode, the current flowing through the portion of a first organic electronic material film in contact with a gate insulator film, the second method including the steps of:
preparing a substrate;
arranging the gate electrode on the substrate;
arranging the gate insulator film on the gate electrode;
arranging the first organic electronic material film on the gate insulator film, the first organic electronic material film containing a first organic electronic material;
arranging a second organic electronic material film on the first organic electronic material film, the second organic electronic material film containing a second organic electronic material and an electron acceptor or an electron donor; and
arranging a source electrode and a drain electrode on the second organic electronic material film such that the source electrode and the drain electrode are spaced apart from each other.

As described in detail below, the organic thin film transistor according to the invention facilitates accumulating electric charges in the channel on the gate insulator film and realizing a high response frequency.
BRIEF DESCRIPTION OF THE DRAWINGS
FIG. 1 is a cross sectional view of a first thin film transistor according to the invention.
FIG. 2 is a cross sectional view of a second thin film transistor according to the invention.
FIG. 3 is a cross sectional view of a third thin film transistor according to the invention.
FIG. 4 describes the curves for explaining the electrical characteristics of the thin film transistor according to an embodiment 2 of the invention.
FIG. 5 describes the curves for explaining the electrical characteristics of the thin film transistor according to an embodiment 12 of the invention.
FIG. 6 is a cross sectional view describing the structure (bottom contact structure) of a conventional organic thin film transistor.
FIG. 7 is a cross sectional view describing the structure (top contact structure) of another conventional organic thin film transistor.
FIG. 8 describes the crystal orientation in an organic electronic material in the bottom contact structure.
FIG. 9 describes the crystal growth in a thin organic electronic material film in the top contact structure.

### DETAILED DESCRIPTION OF THE PREFERRED EMBODIMENTS

Now the present invention will be described in detail hereinafter with reference to the accompanied drawing figures which illustrate the preferred embodiments of the invention. Although the invention will be described in connection with the embodiments thereof, changes and modification are obvious to those skilled in the art without departing from the true spirit of the invention. Therefore, the invention be understood not by the specific descriptions herein but by the appended claims thereof.

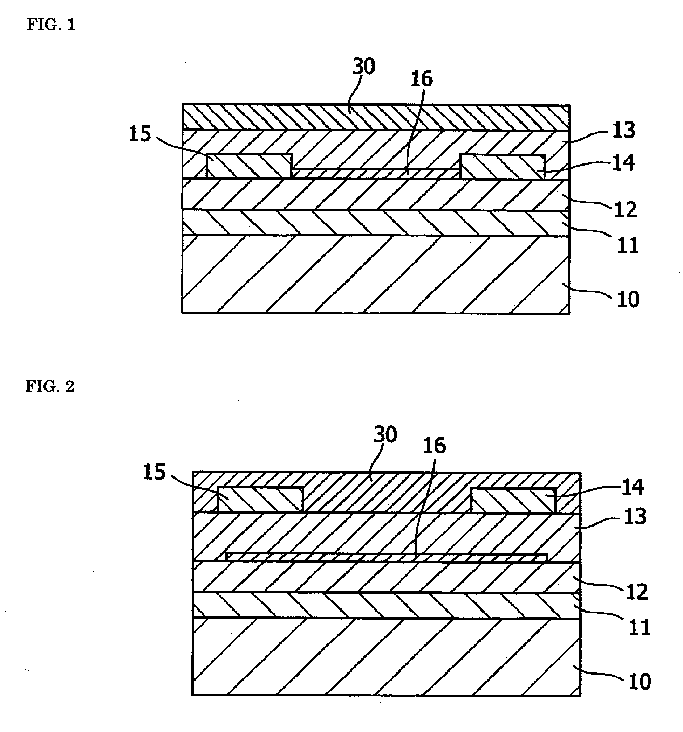

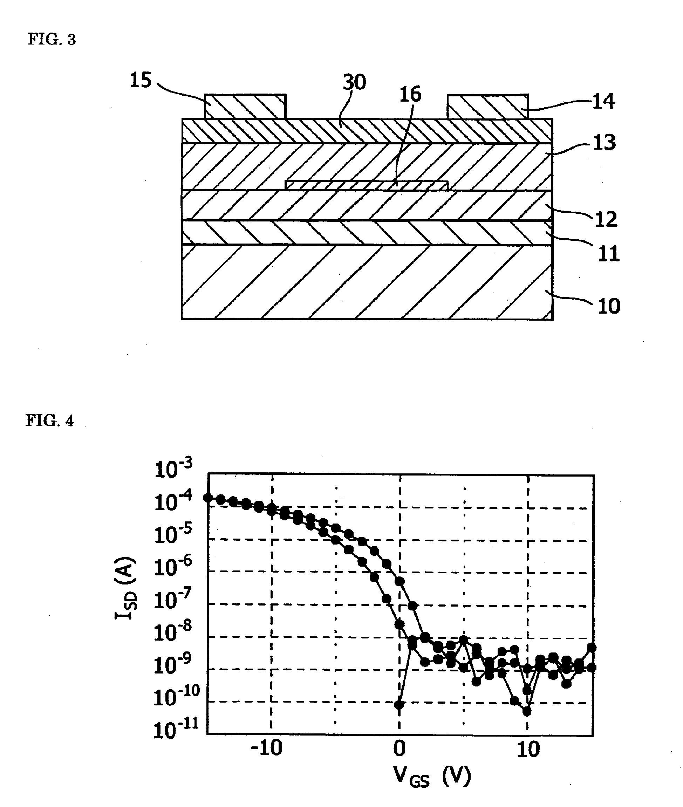

The structures of the thin film field effect transistors according to the invention are described in FIGs. 1, 2 and 3.
The thin film field effect transistor shown in FIG. 1 (hereinafter referred to simply as the "first transistor") and the thin film field effect transistor shown in FIG. 2 (hereinafter referred to simply as the "second transistor") include a substrate 10; a gate electrode 11 on substrate 10; a gate insulator film 12 on gate electrode 11; a first organic electronic material film 13 on gate insulator film 12, first organic electronic material film 13 containing a first organic electronic material; a source electrode 15 and a drain electrode 14 spaced apart from each other and in contact with first organic electronic material film 13, source electrode 15 and drain electrode 14 making a current flow through the portion 16 of first organic electronic material film 13 between source electrode 15 and drain electrode 14 and in contact with gate insulator film 12 (hereinafter referred to as the "channel 16"), the current being controlled by the potential of gate electrode 11; and a second organic electronic material film 30 on the surface of first organic electronic material film 13 opposite to channel 16 in contact with gate insulator film 12, the second organic electronic material film 30 containing a second organic electronic material and an electron acceptor or an electron donor. In the first transistor shown in FIG. 1, source electrode 15 and drain electrode 14 are disposed on gate insulator film 12. Channel 16 is formed in the portion of first organic electronic material film 13 between source electrode 15 and drain electrode 14 and in contact with gate insulator film 12. In the first transistor shown in FIG. 1, channel 16 is as wide as the spacing between source electrode 15 and drain electrode 14. In the second transistor shown in FIG. 2, source electrode 15 and drain electrode 14 are disposed on first organic electronic material film 13. In the second transistor shown in FIG. 2, channel 16 is formed in the portion of first organic electronic material film 13 below source electrode 15 and drain electrode 14, the portion being between source electrode 15 and drain electrode 14 and in contact with gate insulator film 12. In the second transistor shown in FIG. 2, channel 16 is as wide as the distance between the far side of source electrode 15 far from drain electrode 14 and the far side of drain electrode 14. far from source electrode 14.
The thin film field effect transistor shown in FIG. 3 (hereinafter referred to simply as the "third transistor") includes a substrate 10; a gate electrode 11 on substrate 10; a gate insulator film 12 on gate electrode 11; a first organic electronic material film 13 on gate insulator film 12, first organic electronic material film 13 containing a first organic electronic material; a second organic electronic material film 30 on first organic electronic material film 13, second organic electronic material film 30 containing a second organic electronic material and an electron acceptor or an electron donor, a source electrode 15 and a drain electrode 14 on second organic electronic material film 30, source electrode 15 and drain electrode 14 being spaced apart from each other; and source electrode 15 and drain electrode 14 making a current flow through the portion (channel) 16 of first organic electronic material film 13 between source electrode 15 and drain electrode 14 and in contact with gate insulator film 12, the current being controlled by the potential of gate electrode 11. In the third transistor shown in FIG. 3, channel 16 is formed in the portion of first organic electronic material film 13 between source electrode 15 and drain electrode 14 and in contact with gate insulator film 12. In the third transistor shown in FIG. 3, channel 16 is formed in the area between source electrode 15 and drain electrode 14 in the projection onto the substrate major surface.

The electron acceptor or the electron donor doped in the second organic electronic material film in any of the structures according to the invention is ionized by an electron or a hole taken therein, providing the organic electronic material with a hole or an electron. The easiness of ionization of the electron acceptor or the electron donor is roughly determined by the doping material and relation between the highest occupied molecular orbital (hereinafter referred to as the "HOMO") and the lowest unoccupied molecular orbital (hereinafter referred to as the "LUMO") of the organic electronic material. The HOMO of organic electronic material film 30 is measured, for example, by the photoelectric emission spectrum in the air. The LUMO is calculated from the HOMO obtained as described above and the optical energy gap obtained from the optical absorption spectrum. If described accurately, the optical energy gap obtained as described above is a little bit different from the actual energy gap. However, the optical absorption spectrum measured simply and easily is used widely for obtaining the energy gap. These values are discussed as the similar concepts similar to the energy levels of the filled band and the conduction band in the inorganic semiconductor. For example, when the LUMO of the electron acceptor is shallower than the HOMO of the organic electronic material (the upper energy level of the filled band in the inorganic semiconductor) and the difference between them is small enough, i.e. within the so-called forbidden band, the electron acceptor will be ionized easily by the temperature or the electric field to be a negative ion, providing the organic electronic material with a hole. The electron donor behaves similar manner. In the actual combination, the chemical reactivity of the dopant and the organic electronic material, the geometrical shape and the electric dipole moment are influential.

The electric charges supplied are in the vicinity of the electron acceptor or the electron donor as far as any electric field is not applied. When the gate voltage is applied, the supplied electric charges are accumulated in the channel in the boundary between the first organic electronic material film and the gate insulator film. In the conventional structures, e.g. in the bottom contact structure shown in FIG. 6 and in the top contact structure shown in FIG. 7, the electric charges accumulated in the channel are supplied form the source electrode. In contrast, the electric charges accumulated in the channel are supplied form the second organic electronic material film doped with an appropriate impurity in the structures according to the invention. The maximum thickness of the first and second organic electronic material films is 300 nm or thinner. Usually, the first and second organic electronic material films are around 50 nm in thickness. The distance between the source electrode and the drain electrode is at least 1 µm or longer and, usually, around 5 µm. Since the voltage applied to the gate electrode with reference to the source electrode and the voltage applied to the drain electrode with reference to the source electrode are similar to each other, the distance from the electric charge source to the channel in any of the structures according to the invention is two orders of magnitude as short as the distance from the electric charge source to the channel in conventional structures. Moreover, the electric field proportional to the charge migration speed in any of the structures according to the invention is two orders of magnitude as high as the charge migration speed in conventional structures. Therefore, the speed of charge supply to the channel, which has been a limiting factor limiting the frequency response of the conventional organic thin film transistor, is increased remarkably and it becomes possible to improve the frequency characteristics of the organic thin film transistor.

The structure shown in FIG. 1 is formed easily, for example, by depositing source electrode 15 and drain electrode 14 by vacuum deposition and, then by forming first organic electronic material film 13 and second organic electronic material film 30. Second organic electronic material film 30 is doped with an electron acceptor or an electron donor easily by the thermal co-evaporation technique. The structure shown in FIG. 2 is formed easily by the similar methods.
In forming the structure shown in FIG. 3, it is possible to form first organic electronic material film 13 and second organic electronic material film 30 continuously. In the structure shown in FIG. 3, second organic electronic material film 30 is doped with an electron acceptor or an electron donor easily by the thermal co-evaporation technique.

Since any metal is not contained in the second organic electronic material film that supplies electric charges to the channel, any damage is not caused thermally in the second organic electronic material film according to the invention. When the same material is used for the first and second organic electronic materials, film formation is conducted simply and easily. Since the energy barrier between the first and second organic electronic material films is low when the same material is used for the first and second organic electronic materials, the electric charges migrate easily and the electrical resistance is reduced substantially.

As described above, the organic thin film transistors according to the invention facilitate avoiding the problems of the conventional bottom contact and top contact structures, accumulating electric charges in the channel on the gate insulator film and realizing a high response frequency.

For manufacturing the organic thin film transistor shown in FIG. 1, gate electrode 11 is deposited first on substrate 10 by vacuum deposition, sputtering and such a method for film deposition. Then, gate insulator film 12 is formed on gate electrode 11. Gate electrode 11 and gate insulator film 12 are shaped with the respective patterns, if necessary, using shadow masks or through photo-processes. Then, source electrode 15 and drain electrode 14 are formed. Then, first and second organic electronic material films 13 and 30 are formed, resulting in the desired structure.
For manufacturing the organic thin film transistor shown in FIG. 3, gate electrode 11 is deposited first on substrate 10 by vacuum deposition, sputtering and such a method for film deposition. Then, gate insulator film 12 is formed on gate electrode 11. Gate electrode 11 and gate insulator film 12 are shaped with the respective patterns, if necessary, using shadow masks or through photo-processes. Then, first and second organic electronic material films 13 and 30 are formed. Then, source electrode 15 and drain electrode 14 are formed, resulting in the desired structure.

Although the organic thin film transistors according to the embodiments of the invention will be described in detail hereinafter with reference to the accompanied drawing figures, changes and modifications are obvious within the scope of the invention.

### [Embodiment 1]

A tantalum gate electrode 11 is formed on a glass substrate 10 by the usual photo-process and sputtering, resulting in gate electrode 11 of 150 nm in thickness. Then, an anodic oxide film is formed on gate electrode 11. The anodic oxidation is conducted in a solution containing 1 wt % of ammonium borate under the voltage of 70 V for 50 min, resulting in a gate insulator film 12 of 80 nm in thickness.

Then, source electrode 15 and drain electrode 14 are formed of gold vacuum deposition films. The gold film thickness is 80 nm. The channel is 5 µm in length and 100 µm in width. Then, first organic electronic material film 13 of 60 nm in thickness is formed by depositing an acenic compound having the structure described by the structural formula (I-18) (pentacene: supplied from Sigma-Aldrich Corporation) by the vacuum deposition method. The substrate temperature for depositing first organic electronic material film 13 is set at 60 °C. Then, second organic electronic material film 30 of 80 nm in thickness containing 97 atomic % of pentacene (supplied from Sigma-Aldrich Corporation) and 3 atomic % of F₄TCNQ (supplied from Sigma-Aldrich Corporation) is formed by vacuum deposition. The substrate temperature for depositing second organic electronic material film 30 is set at 60 °C. Thus, an organic thin film transistor according to the embodiment 1 having the structure shown in FIG. 1 is obtained.

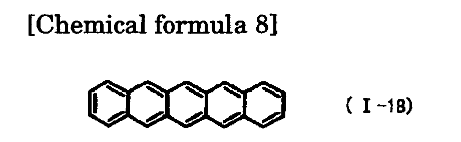

The vacuum deposition installation used for depositing the above described films are evacuated by a diffusion pump and the film depositions are conducted under the degrees of vacuum of 4 × 10⁻⁴ Pa (3 × 10⁻⁶ Torr). Gold and pentacene are evaporated by the resistance heating method. The film deposition speed is 10 nm/sec for gold and 0.4 nm/sec for pentacene. The substrate temperature for depositing the other films than the pentacene film is the room temperature.

### [Embodiment 2]

An organic thin film transistor according to an embodiment 2 is fabricated in the same manner as the organic thin film transistor according to the embodiment 1 except that second organic electronic material film 30 in the organic thin film transistor according to the embodiment 2 contains 95 atomic % of pentacene (supplied from Sigma-Aldrich Corporation) and 5 atomic % of F₄TCNQ (supplied from Sigma-Aldrich Corporation).

### [Embodiment 3]

An organic thin film transistor according to an embodiment 3 is fabricated in the same manner as the organic thin film transistor according to the embodiment 1 except that second organic electronic material film 30 in the organic thin film transistor according to the embodiment 3 contains 90 atomic % of pentacene (supplied from Sigma-Aldrich Corporation) and 10 atomic % of F₄TCNQ (supplied from Sigma-Aldrich Corporation).

### [Embodiment 4]

An organic thin film transistor according to an embodiment 4 is fabricated in the same manner as the organic thin film transistor according to the embodiment 1 except that first organic electronic material film 13 is made of an acenic compound having the structure described by the structural formula (1-13) in the organic thin film transistor according to the embodiment 4.

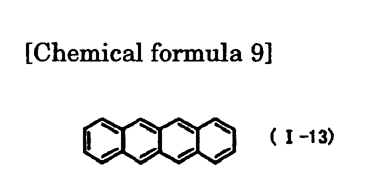

### [Embodiment 5]

An organic thin film transistor according to an embodiment 5 is fabricated in the same manner as the organic thin film transistor according to the embodiment 1 except that the doping rate of F₄TCNQ is 0.5 atomic % and the rest is pentacene in the organic thin film transistor according to the embodiment 5.

### [Embodiment 6]

An organic thin film transistor according to an embodiment 6 is fabricated in the same manner as the organic thin film transistor according to the embodiment 1 except that the doping rate of F₄TCNQ is 20 atomic % and the rest is pentacene in the organic thin film transistor according to the embodiment 6.

### [Embodiment 7]

A first organic electronic material film of C60 is formed by vacuum deposition. A second organic electronic material film containing 96 atomic % of C60 (supplied from Sigma-Aldrich Corporation) and 4 atomic % of pyronine B (supplied from Sigma-Aldrich Corporation) is formed by vacuum deposition. The substrate temperature is the room temperature for depositing the first and second organic electronic material films. A source electrode and a drain electrode are formed by depositing C60. The other conditions are set to be the same with the conditions, under which the organic thin film transistor according to the embodiment 1 is fabricated. Thus, an organic thin film transistor according to the embodiment 7 is fabricated.

### [Embodiment 8]

An organic thin film transistor according to an embodiment 8 is fabricated in the same manner as the organic thin film transistor according to the embodiment 1 except that the doping rate of pyronine B (supplied from Sigma-Aldrich Corporation) is 0.5 atomic % and the rest is pentacene in the organic thin film transistor according to the embodiment 8.

### [Embodiment 9]

An organic thin film transistor according to an embodiment 9 is fabricated in the same manner as the organic thin film transistor according to the embodiment 1 except that the doping rate of pyronine B (supplied from Sigma-Aldrich Corporation) is 20 atomic % and the rest is pentacene in the organic thin film transistor according to the embodiment 9.

### [Embodiment 10]

An organic thin film transistor according to an embodiment 10 is fabricated in the same manner as the organic thin film transistor according to the embodiment 1 except that first organic electronic material film 13 is formed in subsequent to forming an anodic oxide film and, then, source electrode 15 and drain electrode 14 are formed by the vacuum deposition of gold and that the channel is 30 µm in length and 600 µm in width in the organic thin film transistor according to the embodiment 10. The organic thin film transistor according to the embodiment 10 has the structure shown in FIG. 2.

### [Embodiment 11]

A tantalum gate electrode 11 is formed on a glass substrate 10 by the usual photo-process and sputtering, resulting in gate electrode 11 of 150 nm in thickness. Then, an anodic oxide film is formed on gate electrode 11. The anodic oxidation is conducted in a solution containing 1 wt % of ammonium borate under the voltage of 70 V for 50 min, resulting in a gate insulator film 12 of 80 nm in thickness.

First organic electronic material film 13 of 50 nm in thickness is formed by depositing an acenic compound having the structure described by the structural formula (I-18) (pentacene: supplied from Sigma-Aldrich Corporation) by the vacuum deposition method. The substrate temperature for depositing first organic electronic material film 13 is set at 70 °C. Then, second organic electronic material film 30 of 80 nm in thickness containing 99 atomic % of pentacene (supplied from Sigma-Aldrich Corporation) and 1 atomic % of F₄TCNQ (supplied from Sigma-Aldrich Corporation) is formed by vacuum deposition. The substrate temperature for depositing second organic electronic material film 30 is the room temperature. Source electrode 15 and drain electrode 14 are formed of gold vacuum deposition films. The gold film thickness is 50 nm. The channel is 5 µm in length and 100 µm in width. Thus, an organic thin film transistor according to the embodiment 11 having the structure shown in FIG. 3 is obtained.

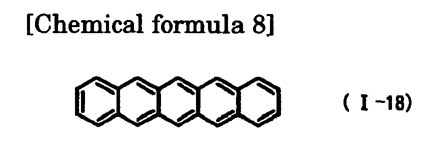

The vacuum deposition installation used for depositing the above described films are evacuated by a diffusion pump and the film depositions are conducted under the degrees of vacuum of 4 × 10⁻⁴ Pa (3 ×10⁻⁶ Torr). Gold and pentacene are deposited by the resistance heating method. The film deposition speed is 0.2 nm/sec for gold and 0.4 nm/sec for pentacene. The substrate temperature for depositing the other films than the pentacene film is the room temperature.

### [Embodiment 12]

An organic thin film transistor according to an embodiment 12 is fabricated in the same manner as the organic thin film transistor according to the embodiment 11 except that second organic electronic material film 30 in the organic thin film transistor according to the embodiment 12 is 20 nm in thickness.

### [Embodiment 13]

An organic thin film transistor according to an embodiment 13 is fabricated in the same manner as the organic thin film transistor according to the embodiment 11 except that second organic electronic material film 30 in the organic thin film transistor according to the embodiment 13 contains 90 atomic % of pentacene (supplied from Sigma-Aldrich Corporation) and 10 atomic % of F₄TCNQ (supplied from Sigma-Aldrich Corporation).

### [Embodiment 14]

An organic thin film transistor according to an embodiment 14 is fabricated in the same manner as the organic thin film transistor according to the embodiment 11 except that the substrate temperature for forming first organic electronic material film 13 is the room temperature in the organic thin film transistor according to an embodiment 14.

### [Comparative example 1]

An organic thin film transistor according to a comparative example 1 is fabricated in the same manner as the organic thin film transistor according to the embodiment 1 except that any second organic electronic material film 30 is not disposed in the organic thin film transistor according to the comparative example 1.

### [Comparative example 2]

An organic thin film transistor according to a comparative example 2 is fabricated in the same manner as the organic thin film transistor according to the embodiment 1 except that the doping rate of F₄TCNQ is 30 atomic % in the organic thin film transistor according to the comparative example 2.

### [Comparative example 3]

An organic thin film transistor according to a comparative example 3 is fabricated in the same manner as the organic thin film transistor according to the embodiment 7 except that any second organic electronic material film 30 is not disposed in the organic thin film transistor according to the comparative example 3.

### [Comparative example 4]

An organic thin film transistor according to a comparative example 4 is fabricated in the same manner as the organic thin film transistor according to the embodiment 7 except that the doping rate of pyronine B (supplied from Sigma-Aldrich Corporation) is 25 atomic % in the organic thin film transistor according to the comparative example 4.

### [Comparative example 5]

An organic thin film transistor according to a comparative example 5 is fabricated in the same manner as the organic thin film transistor according to the embodiment 11 except that any second organic electronic material film 30 is not disposed in the organic thin film transistor according to the comparative example 5.

### [Comparative example 6]

An organic thin film transistor according to a comparative example 6 is fabricated in the same manner as the organic thin film transistor according to the embodiment 11 except that the doping rate of F₄TCNQ is 0 atomic % in the organic thin film transistor according to the comparative example 6.

### [Comparative example 7]

An organic thin film transistor according to a comparative example 7 is fabricated in the same manner as the organic thin film transistor according to the embodiment 14 except that any second organic electronic material film 30 is not disposed in the organic thin film transistor according to the comparative example 7.

### [Results]

Transistor operations of the p-channel type are confirmed in the thin film transistors according to the embodiments 1 through 6 and the comparative examples 1 and 2. Transistor operations of the n-channel type are confirmed in the thin film transistors according to the embodiments 7 through 9 and the comparative examples 3 and 4. The characteristics of the thin film transistor according to the embodiment 2 are described as typical ones in FIG. 4. The mobility values and the frequency characteristics of the thin film transistors according to the embodiments 1 through 10 and the comparative examples 1 through 4 are listed in the following Table 1.
Transistor operations of the p-channel type are confirmed for the thin film transistors according to the embodiments 11 through 14 and the comparative examples 5 and 6. The characteristics of the thin film transistor according to the embodiment 12 are described as typical ones in FIG. 5. The mobility values and the frequency characteristics of the thin film transistors according to the embodiments 11 through 14 and the comparative examples 5 through 7 are listed also in the following Table 1.
The frequency characteristics are determined from the follow-up manner how the current between the source and the drain follows up the gate voltage modulated by a sinusoidal wave having a predetermined frequency such that the gate voltage is changed sinusoidally between -10 V and 0 V at the voltage between the source and the drain set at -10 V. Although the thin film transistors according to the comparative examples exhibit the mobility reasonable for the organic electronic material, the response frequencies thereof are lower than 100 Hz. Although the mobility values for the thin film transistor according to the embodiments of the invention are similar to the mobility values for the thin film transistor according to the comparative examples, the thin film transistor according to the embodiments of the invention exhibit greatly improved frequency characteristics. The frequency characteristics are improved greatly, presumably because the charge accumulation speed is improved due to the electric charges accumulation in the channel from the second organic electronic material film near the channel. It is considered that the time constant for charging up the electrostatic capacitance formed of the gate insulator film is decreased due to the improved charge accumulation speed and a high response frequency is obtained.

**Table 1**

| | Mobility (cm²/Vₛ) | Vth (V) | Response frequencies (Hz) |
|---|---|---|---|
| Embodiment 1 | 0.28 | 1.2 | 1200 |
| Embodiment 2 | 0.23 | 2.4 | 1400 |
| Embodiment 3 | 0.25 | 3.7 | 1000 |
| Embodiment 4 | 0.10 | 2.5 | 400 |
| Embodiment 5 | 0.30 | 0.5 | 300 |
| Embodiment 6 | 0.21 | 5.8 | 400 |
| Embodiment 7 | 0.10 | -2.4 | 550 |
| Embodiment 8 | 0.11 | -0.9 | 300 |
| Embodiment 9 | 0.10 | -4.5 | 200 |
| Embodiment 10 | 0.45 | -3.2 | 200 |
| Embodiment 11 | 0.66 | -4.9 | 1400 |
| Embodiment 12 | 0.37 | -0.29 | 1200 |
| Embodiment 13 | 0.32 | -3 | 1600 |
| Embodiment 14 | 0.35 | -1.93 | 1200 |
| Comparative example 1 | 0.27 | -0.4 | 60 |
| Comparative example 2 | 0.24 | 7.7 | 40 |
| Comparative example 3 | 0.12 | 0.7 | 20 |
| Comparative example 4 | 0.11 | -6.4 | 10 |
| Comparative example 5 | 0.07 | -4.2 | 40 |
| Comparative example 6 | 0.13 | -7.1 | 40 |
| Comparative example 7 | 0.39 | -1.3 | 60 |

As described above, the organic thin film transistor according to the invention facilitates accumulating electric charges in the channel on the gate insulator film and realizing a high response frequency.

## Claims

1. A thin film field effect transistor comprising:
a gate electrode;
a gate insulator film on said gate electrode;
a first organic electronic material film on said gate insulator film, said first organic electronic material film comprising a first organic electronic material;
a source electrode in contact with said first organic electronic material film;
a drain electrode in contact with said first organic electronic material film;
said source electrode and said drain electrode being spaced apart from each other;
said first organic electronic material film comprising a portion between said source electrode and said drain electrode, said portion of said first organic electronic material film being in contact with said gate insulator film, said portion of said first organic electronic material film providing a current with a path, said current being controlled by the potential of said gate electrode;
a second organic electronic material film on the surface of said first organic electronic material film between said source electrode and said drain electrode, said the surface being on the side opposite to said portion of said first organic electronic material film in contact with said gate insulator film; and
said second organic electronic material film comprising a second organic electronic material and an electron acceptor or an electron donor.

2. A thin film field effect transistor comprising:
a gate electrode;
a gate insulator film on said gate electrode;
a first organic electronic material film on said gate insulator film, said first organic electronic material film comprising a first organic electronic material;
a source electrode above said first organic electronic material film;
a drain electrode above said first organic electronic material film;
said source electrode and said drain electrode being spaced apart from each other;
said first organic electronic material film comprising a portion in contact with said gate insulator film, said portion of said first organic electronic material film providing a current with a path, said current being controlled by the potential of said gate electrode;
a second organic electronic material film between said first organic electronic material film and said source electrode, said second organic electronic material film being between said first organic electronic material film and said drain electrode; and
said second organic electronic material film comprising a second organic electronic material and an electron acceptor or an electron donor.

3. The thin film field effect transistor according to Claims 1 or 2, wherein at least one of said first organic electronic material and said second organic electronic material is an acenic material described by the following structural formula (I), 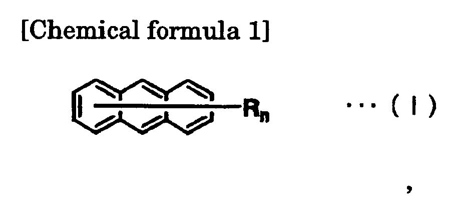 wherein said R is hydrogen, an alkyl group comprising from 1 to 6 carbons which may have one or more substituents, an aryl group which may have one or more substituents, an alkoxy group comprising from 1 to 6 carbons which may have one or more substituents, 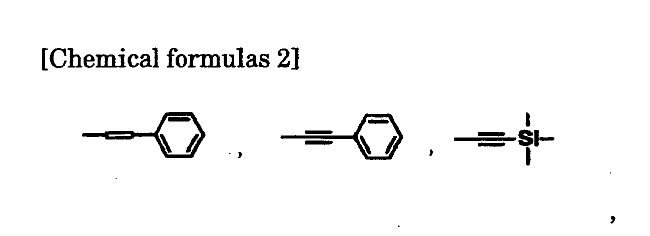 or a residue that forms with an anthracene skeleton an aromatic ring or a heterocycle and said n is any of the integers 1 through 10.

4. The thin film field effect transistor according to any one of Claims 1 through 3, wherein the electric charge that flows through said first organic electronic material is a hole and said electron acceptor is 2,3,5,6-tetrafluoro-7,7,8,8- tetracyanoquinodimethane described by the following structural formula (II).

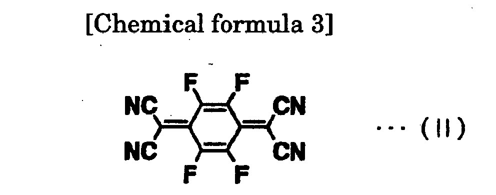

5. The thin film field effect transistor according to Claim 4, wherein the doping amount of said 2,3,5,6-tetrafluoro-7,7,8,8-tetracyanoquinodimethane is 20 atomic % or less.

6. The thin film field effect transistor according to any one of Claims 1 thorough 3, wherein the electric charge that flows through said first organic electronic material is an electron and said electron donor is pyronine B described by the following structural formula (III).

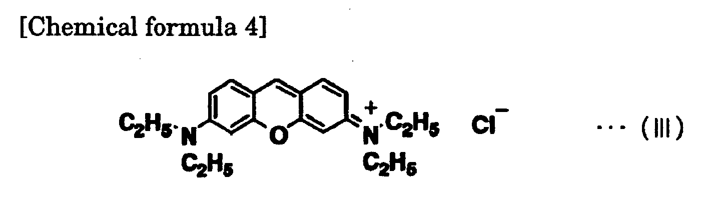

7. The thin film field effect transistor according to Claim 6, wherein the doping amount of said pyronine B is 20 atomic % or less.

8. A method for manufacturing a thin film field effect transistor that controls, with the potential of a gate electrode, the current flowing through the portion of a first organic electronic material film in contact with a gate insulator film, the first method including the steps of:
preparing a substrate;
arranging the gate electrode on the substrate;
arranging the gate insulator film on the gate electrode;
arranging the first organic electronic material film on the gate insulator film, the first organic electronic material film containing a first organic electronic material;
arranging a source electrode and a drain electrode in advance or in subsequent to the step of arranging the first organic electronic material film such that the source electrode and the drain electrode are in contact with the first organic electronic material film and such that the source electrode and the drain electrode are spaced apart from each other; and
arranging a second organic electronic material film containing a second organic electronic material and an electron acceptor or an electron donor on the surface of the first organic electronic material film between the source electrode and the drain electrode, the surface being on the side opposite to the portion of the first organic electronic material film in contact with the gate insulator film.

9. A method for manufacturing a thin film field effect transistor that controls, with the potential of a gate electrode, the current flowing through the portion of a first organic electronic material film in contact with a gate insulator film, the second method including the steps of:
preparing a substrate;
arranging the gate electrode on the substrate;
arranging the gate insulator film on the gate electrode;
arranging the first organic electronic material film on the gate insulator film, the first organic electronic material film containing a first organic electronic material;
arranging a second organic electronic material film on the first organic electronic material film, the second organic electronic material film containing a second organic electronic material and an electron acceptor or an electron donor; and
arranging a source electrode and a drain electrode on the second organic electronic material film such that the source electrode and the drain electrode are spaced apart from each other.
